# EUROPEAN PATENT SPECIFICATION

(11) **EP 4 189 750 B1**
(45) Date of publication and mention of the grant of the patent: **14.10.2026**
(21) Application number: 21759143.7
(22) Date of filing: 29.07.2021
(51) Int. Cl.: H10F 30/221, H10F 30/222, H10F 30/24

(54) **DOUBLE PHOTODIODE ELECTROMAGNETIC RADIATION SENSOR DEVICE**
DOPPELPHOTODIODE FÜR ELEKTROMAGNETISCHE STRAHLUNG
DISPOSITIF DE CAPTEUR DE RAYONNEMENT ÉLECTROMAGNÉTIQUE À DOUBLE PHOTODIODE

(30) Priority: 31.07.2020 IT 202000018760
(43) Date of publication of application: 07.06.2023
(73) Proprietor: Politecnico di Milano, 20133 Milano (IT); Università Degli Studi Roma Tre, 00154 Roma (IT)
(72) Inventor: FRIGERIO, Jacopo, 20133 Milano (IT); ISELLA, Giovanni, 20133 Milano (IT); BALLABIO, Andrea, 20133 Milano (IT); DE IACOVO, Andrea, 00146 Roma (IT); COLACE, Lorenzo, 00146 Roma (IT)
(74) Representative: Praxi Intellectual Property Milano
(86) International application number: PCT/IB2021/056910
(87) International publication number: WO 2022/024025

(56) References cited:
- CN-A- 106 531 822
- US-A- 5 113 076
- US-B1- 6 518 558
- DE IACOVO ANDREA ET AL: "Design and Simulation of Ge-on-Si Photodetectors With Electrically Tunable Spectral Response", JOURNAL OF LIGHTWAVE TECHNOLOGY, IEEE, USA, vol. 37, no. 14, 15 July 2019 (2019-07-15), pages 3517 - 3525, XP011734187, ISSN: 0733-8724, [retrieved on 20190708], DOI: 10.1109/JLT.2019.2917590
- SIMOLA E. TALAMAS ET AL: "Voltage-tunable dual-band Ge/Si photodetector operating in VIS and NIR spectral range", OPTICS EXPRESS, vol. 27, no. 6, 18 March 2019 (2019-03-18), US, pages 8529, XP055795521, ISSN: 1094-4087, DOI: 10.1364/OE.27.008529
- WILSON J A ET AL: "INTEGRATED TWO-COLOR DETECTION FOR ADVANCED FPA APPLICATIONS", PROCEEDINGS OF SPIE, IEEE, US, vol. 2274, 24 July 1994 (1994-07-24), pages 117 - 125, XP000646263, ISBN: 978-1-62841-730-2, DOI: 10.1117/12.189237

## Description

### TECHNICAL FIELD

The present invention relates to electromagnetic radiation sensors of the double photodiode type.

### STATE OF THE ART

Double photodiode electromagnetic radiation sensors allow the detection of an optical signal in two different spectral bands.

The first demonstration of how the use of two photodiodes in a back-to-back configuration allows the detection of an optical signal in two different spectral bands is reported in the article J.C. Campbell et al. "Dual-wavelength demultiplexing InGaAsP photodiode," Applied Physics Letters 34, 401 (1979).

This paper describes the use of two layers of InGaAsP (with different concentrations of the individual chemical elements) as photosensitive elements in the 0.8-1.1 µm and 1.0-1.3 µm bands. The structure is deposited on an InP substrate and has three independent metal contacts.

The paper E.R. Blazejewski et al, "Bias switchable dual band HgCdTe infrared photodetector," J. Vac. Sci. Tech. B, 10, 1626 (1992) describes a back-to-back configuration used to manufacture a mid-infrared and far-infrared active optical sensor using two HgCdTe alloys deposited on a CdZnTe substrate as active layers. In this case the device is photosensitive in the 2-4.3 um and 4.5-8.2 um bands.

Paper L. Colace et al, "Solid state wavemeter with InGaAsP/InGaAs two-diode heterostructure," Electronics Letters 38,735 (2002) describes a back-to-back structure using two layers of InGaAsP with different band gaps deposited on InP to measure the wavelength of a laser in the 30 nm range.

Document US-A-6342720 describes a photodetector comprising a double diode consisting of a silicon Schottky diode and a PIN-type SiGe diode.

Document US-A-6043517 discloses a photodetector that operates for two wavelength ranges and comprises two detectors arranged one above the other. A silicon Schottky diode forms a first detector that absorbs light with wavelengths shorter than 0.9 µm. A second detector (a Si/SiGe diode) absorbs light with wavelengths greater than 1µm and less than 2 µm.

The paper E. Talamas Simola et al. "Voltage-tunable dual-band Ge/Si photodetector operating in VIS and NIR spectral range" Vol. 27, No. 6; 18/03/2019, OPTICS EXPRESS 8529, describes a device having a germanium-on-silicon epitaxial structure consisting of two photodiodes connected back-to-back and such that it operates as a photodetector for a wide band of wavelengths.

The paper Andrea De Iacovo et al, "Design and Simulation of Ge-on-Si Photodetectors With Electrically Tunable Spectral Response", JOURNAL OF LIGHTWAVE TECHNOLOGY, VOL. 37, NO. 14, JULY 15, 2019 3517, describes a double photodiode electromagnetic radiation sensor device.

### SUMMARY OF THE INVENTION

The present invention addresses the problem of providing an electromagnetic radiation sensor, of the two-photodiode type in a back-to-back configuration, which has an alternative structure to the known ones, without being of complex manufacturing and which is compatible with the processing techniques of CMOS electronics allowing, consequently, the integration of the sensor with the electronic control and readout modules of the sensor itself.

In accordance with a first aspect, the present invention relates to a double photodiode electromagnetic radiation sensor device as defined in independent claim 1 and to particular embodiments thereof as defined in dependent claims 2-13.

According to a second aspect, the present invention has as its object an electromagnetic radiation detection system according to claim 14 and by a particular embodiment thereof, as defined by dependent claim 15.

### BRIEF DESCRIPTION OF THE DRAWINGS

The present invention is hereinafter described in detail, by way of example and not limitation, with reference to the accompanying drawings, in which:
- figure 1 shows the circuit diagram of a two-photodiode sensor device in back-to-back configuration;
- figure 2 shows, as an example, the trend of the current generated by the sensor device as a function of wavelength and regulation voltage;
- figure 3 shows, according to a first embodiment, a cross section of the structure of the sensor device integrated in a substrate of semiconductor material;
- figure 4 shows a plan view of the structure of the sensor device of the first embodiment;
- figure 5 shows, in accordance with a second embodiment, a cross-section of a structure of said sensor device integrated into a substrate of semiconductor material;
- figure 6 shows, in accordance with a third embodiment, a cross-section of a structure of said sensor integrated in a substrate of semiconductor material;
- Figure 7 shows, in accordance with a fourth embodiment, a cross-section of a structure of said sensor integrated in a substrate of semiconductor material;
- Figure 8 shows, in accordance with a fifth embodiment, a cross-section of a structure of said sensor integrated in a substrate of semiconductor material
- Figure 9 schematically shows a spectrum detection system including said sensor device.

### DETAILED DESCRIPTION

In this description, similar or identical elements or components will be indicated in the drawings by the same identifying symbol.

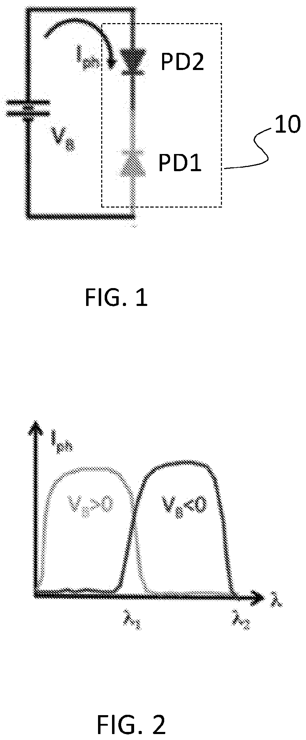

Figure 1 shows a circuit scheme of a double photodiode sensor device 10 (also referred to herein as "sensor" for brevity). The sensor 10 includes a first photodiode PD1 and a second photodiode PD2 arranged in a "back-to-back" configuration i.e., with cathodes (or anodes) electrically connected to each other. These first and second photodiodes PD1 and PD2 are adjustable by applying a suitable voltage V_{B} to the remaining anodes (or cathodes).

In particular, the first photodiode PD1 (hereinafter, also referred to as "PD1 diode") is obtained from a semiconductor material with energy gap (i.e., band gap) E_{g1} and the second photodiode PD2, is obtained from another semiconductor material with energy gap E_{g2}< E_{g1}.

The first diode PD1 is configured to collect and convert into an electrical signal (i.e., a photocurrent Iph) the radiation with wavelength λ between a first minimum wavelength λₘᵢₙ(PD1) and a first maximum wavelength λₘₐₓ(PD1)=hc/ E_{g1} (with hc universal constants).

The second photodiode PD2 (hereafter also called "PD2 diode") is configured to collect and convert into an electrical signal (a corresponding photocurrent Iph) the radiation with wavelengths ranging from a second minimum wavelength λₘᵢₙ(PD2) to a second maximum wavelength λₘₐₓ(PD2)= hc/E_{g2} with λₘᵢₙ(PD2) < λₘₐₓ(PD1).

As an example in the case of silicon, indicative values of λₘᵢₙ(PD1) and λₘₐₓ(PD1) are 400 nm and 1100 nm, respectively, and in the case of germanium, indicative values of λₘᵢₙ(PD2) and λₘₐₓ(PD2) are 400 nm and 1800 nm, respectively.

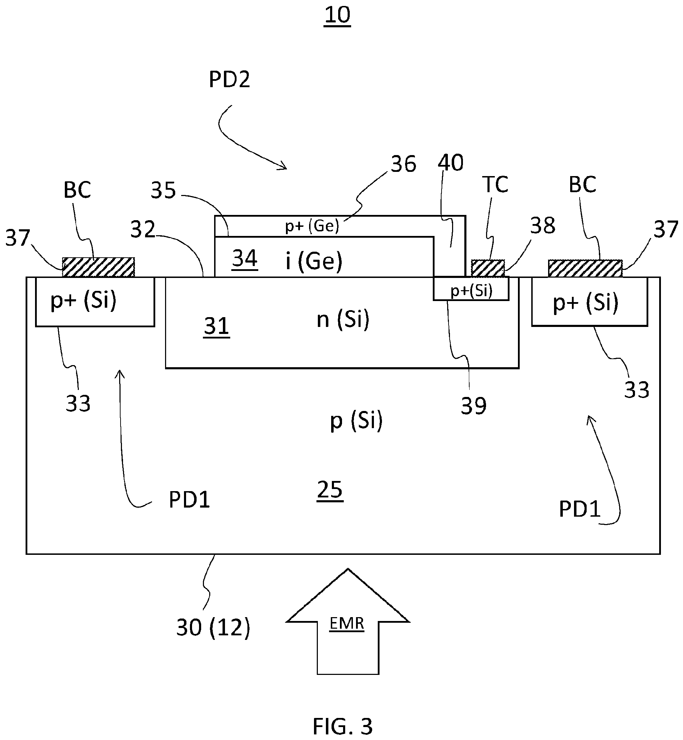

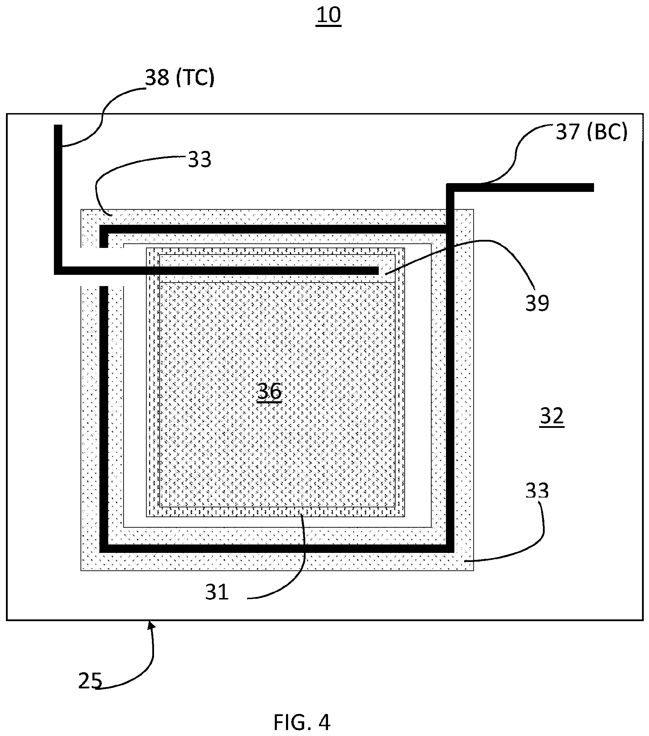

An exemplary embodiment of the sensor structure 10 is illustrated in Figures 3 and 4 (in which the various layers represented are not necessarily to scale). In the following description, reference will be made, by way of example, to the materials silicon and germanium.

As shown in Figure 3 and Figure 4, the sensor 10 includes a substrate 25 made of a first semiconductor material (in the example, shown, silicon) having, for example, p-type doping. The substrate 25 defines a first face 30 and an opposing second face 32.

The first face 30 constitutes an exposed region from which the electromagnetic radiation EMR penetrates. Note that the substrate 25 of the sensor 10 in Figure 3 may be n-type.

A first doped region 31 is formed in the substrate 25, of the same material as the substrate, but with a doping opposite to that of the substrate 25 and that is, according to the example, with an n-type doping. The first doped region 31 extends from the second face 32 of the substrate 25 towards the interior of the substrate itself, without reaching, the first face 30.

Note that said first doped region 31 is intended to act as a common electrode (according to the example, a cathode) to the first diode PD1 and the second diode PD2.

A second doped region 33 is formed within the substrate 25 having, according to the example, a doping of the same type as the substrate 30 but higher, i.e., a p+ type doping. The second doped region 33 extends from the second face 32 toward the interior of the substrate 25 without reaching the first face 30, with a depth less than, for example, that of the first doped region 31.

For example, the second doped region 33 is developed within the substrate 25 so as to laterally surround, in an open loop, the first doped region 31.

Note that the second doped region 33 is intended to act as an additional electrode (in this example, as an anode) for the first PD1 diode.

Further, the sensor 10 includes a layer made of a second semiconductor material 34 (made of germanium, according to the example) placed on the second face 32 of the substrate 25 and so as to be in contact with the first doped region 31. Said germanium layer 34 is, for example, intrinsic germanium. The germanium layer 34 is such as to define a third face 35 opposed to the second face 32.

For example, the intrinsic germanium layer 34 results in facing part of the first doped region 31 (in particular, a central portion thereof), without entirely covering it.

Note that, according to the example, the germanium layer 34 is intended to operate as an intrinsic layer of the second PD2 diode.

Over the third face 35 of the intrinsic germanium layer 34 is placed a doped layer 36 (in germanium) having, according to the example, a high p-type doping (i.e., a p+ doping). The doped layer 36 is intended to act as an anode for the second diode PD2.

The sensor 10 has metal contacts arranged to contact the second doped region 33 at said second face 32 and the doped layer (36).

In particular, according to the embodiment form of Figure 3, the sensor 10 is provided with a first metal layer 37 arranged above second doped region 33 (i.e., the anode of the first diode PD1), so as to form a first ohmic contact BC.

Further, the sensor 10 includes a second metal layer 38 that forms a second ohmic contact TC electrically connected to the doped layer 36.

According to this first embodiment, the connection between the second ohmic contact TC and the doped layer 36 (i.e., the anode of the second PD2 diode) is made by means of a first high-doped well 39 (i.e., a high-conductivity well) and a second high-doped well 40.

The first high-doped well 39 extends from the second face 32 inwardly into the first doped region 31 (n-type) and has, according to the example, a p+ doping. The second ohmic contact TC is disposed on the second face 32 in contact with a portion of the high doping well 39.

The second high-doped well 40 extends, within the germanium layer 34, from the doped layer 36 (with which it is in contact) to the first high-doped well 39 at the second face 32. According to the example, the second high-doped well 40 is made of p+ doped germanium.

Summarizing, the first diode PD1 comprises the first doped region 31, a portion of the substrate 25, and the second doped region 33. The second diode PD2 comprises the first doped region 31, the intrinsic germanium layer 34, the doped layer 36, and the first and second high-doped wells 39 and 40.

The sensor 1 can be manufactured using conventional semiconductor material integration techniques that are compatible with CMOS integration techniques.

For example, the first doped region 31, the second doped region 33, the doped layer 36, the first high dopant well 39, and the second high dopant well 40 may be formed by implantation techniques and/or by spin-on dopant and/or deposition techniques (including epitaxy, sputtering, evaporation).

The intrinsic germanium layer 34 may be formed by chemical and/or physical deposition techniques such as: epitaxy, sputtering, evaporation or even transfer as wafer bonding.

For example, the intrinsic germanium layer 34 may be 500 nm to 3 µm thick. In accordance with the example, the doped layer 36 (i.e., the anode of the second PD2 diode) may be 5 to 200nm thick.

The intrinsic germanium layer 34 is entirely within the first doped region 31 of the silicon substrate 25 and, therefore, it is possible to deposit the intrinsic germanium layer 34 by techniques such as selective deposition (e.g., oxide window deposition), or it is possible to deposit the germanium layer 34 over the entire substrate 25 and then define the geometry of the layer 34 itself by selective removal techniques (photolithography).

The first diode PD1, being made of silicon, is such as to collect and convert into an electrical signal (i.e., the current Iph) the radiation in the visible and near infrared and then the radiation having, indicatively, a minimum wavelength λₘᵢₙ(PD1) of 400nm and a maximum wavelength λₘₐₓ(PD1) of 1100 nm. The VIS (Visible) band is, as known, included in the wavelength range 400 nm - 700 nm. The Near InfraRed (NIR) band extends from 700 nm to 1100 nm.

The second diode PD2 made at least partially of germanium, is configured to collect and convert into an electrical signal (i.e., the current Iph) the radiation having, indicatively, minimum wavelength λₘᵢₙ(PD2) 400 nm and maximum wavelength λₘₐₓ(PD2) of 1800 nm.

As known, the near infrared (NIR) band extends from 700 nm to 1100 nm, while the short wave infrared (SWIR) band is included in the wavelength range 1100 nm - 3000 nm.

In other words, the sensor 10, when fabricated using silicon for the PD1 photodiode and germanium for the PD2 photodiode as shown in the particular embodiment form in Figure 3, can operate in the visible, near infrared to part of the short wave infrared.

Regarding the operation of sensor 10, note that the bias voltage V_{B} is conventionally understood as the voltage difference between the second ohmic contact TC and the first ohmic contact BC. According to this definition, for positive bias voltages V_{B}, the second diode PD2 biases directly and the first diode PD1 biases inversely, and vice versa for negative voltages V_{B}.

When the sensor 10 is illuminated on the side of the semiconductor with energy gap E_{g1} (i.e., at the first face 30 of the diode PD1, according to the example), the first photodiode PD1 will absorb the portion of the higher energy light radiation and the second photodiode PD2 will be illuminated by the only light radiation that cannot be absorbed by the gap semiconductor E_{g1}.

The photodiode made with the gap semiconductor E_{g1} (i.e. the first diode PD1) is, therefore, able to generate photocurrent only in the presence of light radiation at low wavelength (λ<hc/E_{g1}, with hc universal constants) while, on the contrary, the second photodiode PD2 responds only to photons with wavelength λ greater than λmax(PD1) and less than λmax(PD2): ${λ}_{max} \left(PD1\right) < λ < {λ}_{max} \left(PD2\right) .$

The total photocurrent generated by sensor 10 will be given by the difference between the photocurrents generated by the two different photodiodes PD1 and PD2.

This photocurrent Iph can be measured by connecting to the first and second ohmic contacts BC and TC with a corresponding electronic conditioning and acquisition system.

More in detail, when the first diode PD1 is inversely biased it is able to generate the photocurrent Iph when illuminated with radiation with wavelength λ between λₘᵢₙ(PD1) and λₘₐₓ(PD1), while the second diode PD2 is directly biased and is therefore optically inactive, but allows the circulation of the current Iph.

Vice versa, when the second diode PD2 is reverse biased it is able to generate the photocurrent Iph (if illuminated with radiation wavelength λ between λₘₐₓ(PD1) and λₘₐₓ(PD2), while the first diode PD1 is direct biased and is therefore optically inactive, but allows the circulation of the current Iph.

Acting on the bias voltage V_{B} it is possible to electrically select the spectral response of the sensor 10. Figure 2 shows, as an example, the trend of the current Iph as a function of wavelength, for two extreme values of the bias voltage V_{B}.

Depending on the applied bias voltage V_{B} it will be possible to change the collection efficiency of the two junctions associated with the two diodes PD1 and PD2; in particular, as the collection efficiency of the junction with gap E_{g1} increases, it will be observed a decrease in the collection efficiency of the junction with gap E_{g2} and vice versa. This approach allows the responsivity spectrum of sensor 10 varying continuously.

It should be noted that although silicon and germanium were referred to in the example of Figure 1, the sensor 10 may be manufactured by other semiconductor materials. For example, other possible materials capable of satisfying the aforementioned relationships between the photoresponse bands of the first diode PD1 and/or the second diode PD2 include semiconductor materials chosen from one of the following types:
a) III-V semiconductors (e.g., GaAs, InAs, InP ) and alloys thereof;
b) II-VI semiconductors (e.g., ZnSe, ZnTe, CdSe, CdTe, HgTe, PbS, PbSe) and their alloys;
c) IV semiconductors (e.g., Si, Ge, GeSn ) and their alloys.

The form of realization of the sensor 10 described above is not complex to manufacture and, in addition, has the advantage of presenting the metal contacts of the sensor on the same side of the substrate 25 in which it is integrated resulting, therefore, of "planar" type.

The flatness of the sensor device 10 allows its monolithic integration on silicon substrates in which there are other electronic circuits made with CMOS processing techniques. In this way it is possible to realize simultaneously the sensor device and the electronic conditioning and acquisition system on the same substrate, using similar processing technologies that represent an industry standard.

Even when only the sensor device is fabricated on a silicon substrate, the presence of metal contacts TC and BC placed on the same face of the device facilitates the subsequent connection of the latter to external circuits and electronic systems for conditioning and acquisition of the photocurrent signal.

In the latter case, the sensor device 10 can be connected to the external circuitry by means of micro-soldering techniques (bump-bonding, wire bonding, Cu-Cu bonding) or through an electronic connection board (PCB), as will also be specified later.

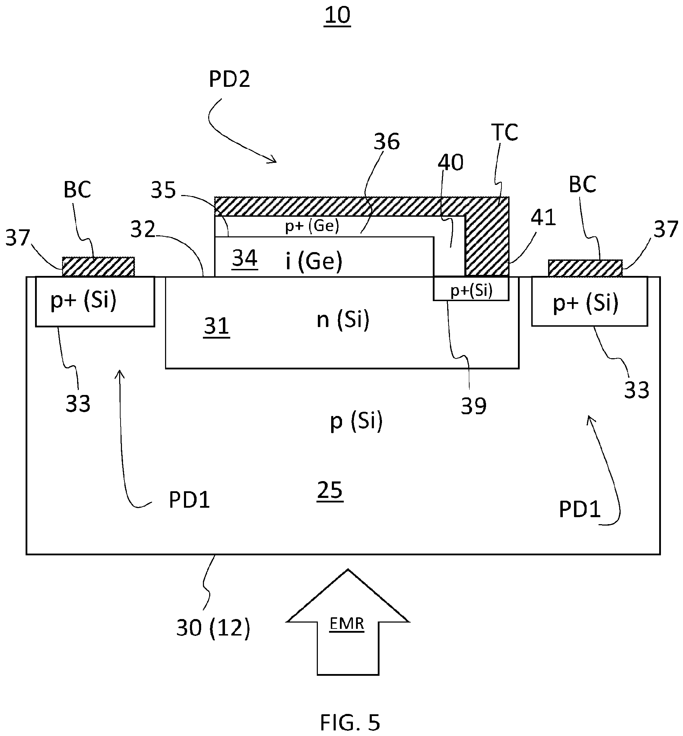

Figure 5 refers to a second embodiment of the sensor 10, similar to that of Figures 3 and 4 but in which the second ohmic contact TC is made by means of a metal layer 41 covering the doped layer 36 (p+, Ge) and the second high-doped well 40, contacting the first high-doped well 39 at the second face 32. In this case, the second TC ohmic contact results directly connected to the doped layer 36 and the second high-doped well 40 as well, providing a better distribution of the electric field within the second PD2 photodiode and decreasing the series resistance effects.

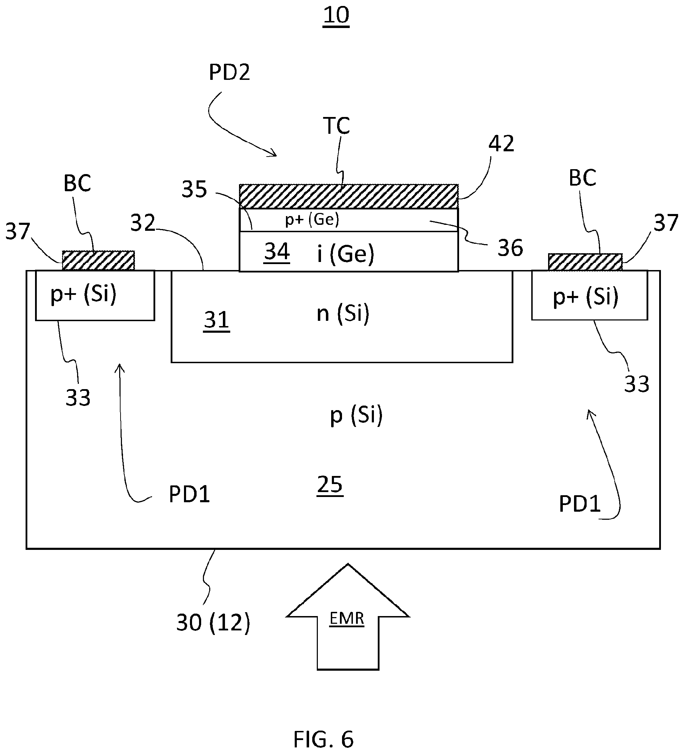

Figure 6 relates to a third embodiment of sensor 10, similar to that of Figures 3 and 4, but in which the first and second high-doped wells 39 and 40 are not provided. In the embodiment form of figure 6, the second TC ohmic contact is made by means of a fourth metal layer 42 that covers the doped layer 36, resulting in spacing from the second face 32. In this case, the absence of the high doping wells 39 and 40 allows further simplification of the fabrication process of the sensor device.

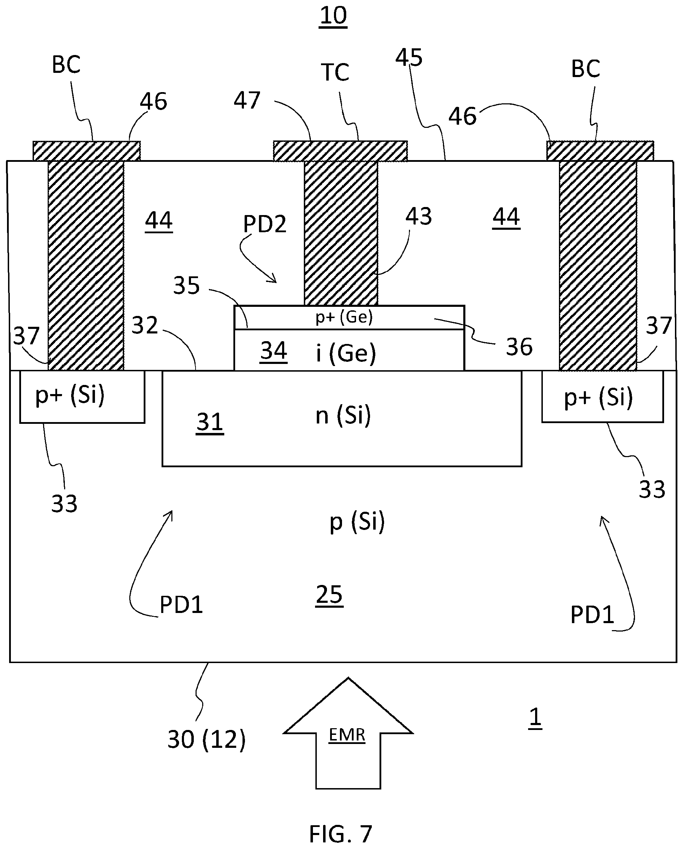

Figure 7 refers to a fourth embodiment of the sensor 10, which is similar to the third embodiment of Figure 6 but in which the second ohmic contact TC is obtained by means of a fifth metal layer 43 that only partially covers the doped layer 36.

Furthermore, according to the fourth embodiment of the sensor 10, the first metal layer 37 (forming the first ohmic contact BC) and the fifth metal layer 43, (forming the second ohmic contact TC) are vertically extended within an insulating layer 44 (e.g., silicon dioxide) arranged to cover part of the second face 32 and part of the doped layer 36.

In particular, the first metal layer 37 and the fifth metal layer 43 form, on a free face 45 of the insulating layer 44, a first contact pad 46 and a second contact pad 47, respectively.

This fourth embodiment allows all the metal contacts to be made at the same height in correspondence with the free face 45; consequently, connection of the sensor device 10 to any external electronic systems is easier due to the absence of differences in height between the various metal contacts.

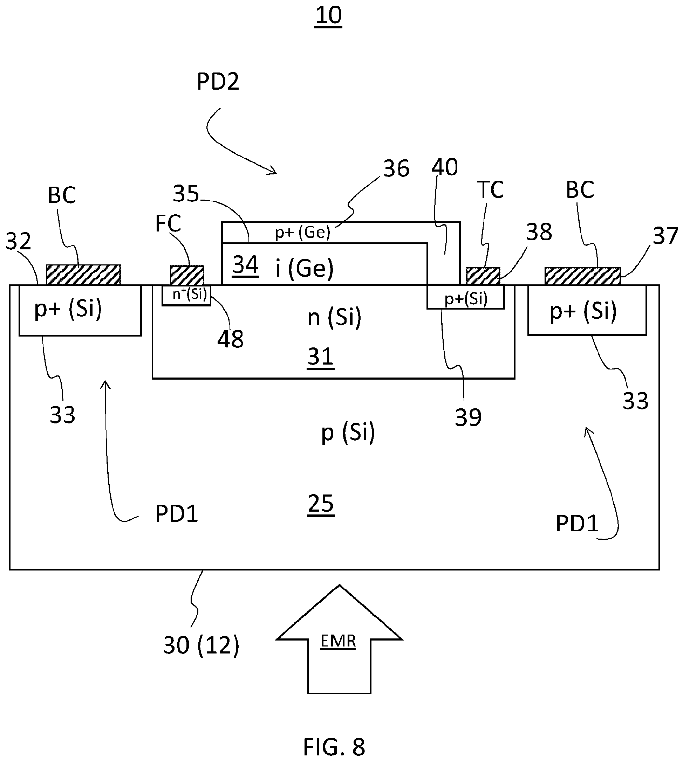

Figure 8 refers to a fifth embodiment of the sensor 10, similar to the first embodiment in Figure 3 but further comprising a third ohmic contact FC (electrically isolated from the first and second ohmic contacts BC and TC), made by a corresponding metal layer.

Said third ohmic contact FC extends on the second face 32 above a third high-doped well 48. The third high-doped well 48 is, according to the example, made of silicon and is made internally to the first doped region 31, presenting a higher doping but of the same type as that of the first doped region 31, i.e., according to the example, an n+ doping.

The third ohmic contact FC, placed in contact with the first doped region 31 (which acts as a cathode for the first diode PD1 and second diode PD2), offers the advantage of allowing to bias the two photodiodes PD1 and PD2 independently of each other, allowing to acquire two different photocurrent signals, for example: one related to the VIS band (PD1) and the other related to the NIR-SWIR band (PD2).

Regarding the possible uses, the sensor 10 can be employed to realize a camera capable of acquiring images in two different bands (for example, in the VIS-NIR and in the SWIR). In addition, sensor 10 can be used in a spectrum detection system for the purpose of spectral analysis of incident radiation or to realize a hyperspectral imaging sensor system.

For example, for the realization of the two-band imaging camera or the hyperspectral imaging sensor system, a plurality of sensors 10 having a structure similar to that described above can be integrated into the same substrate 25, resulting side-by-side and forming a two-dimensional array.

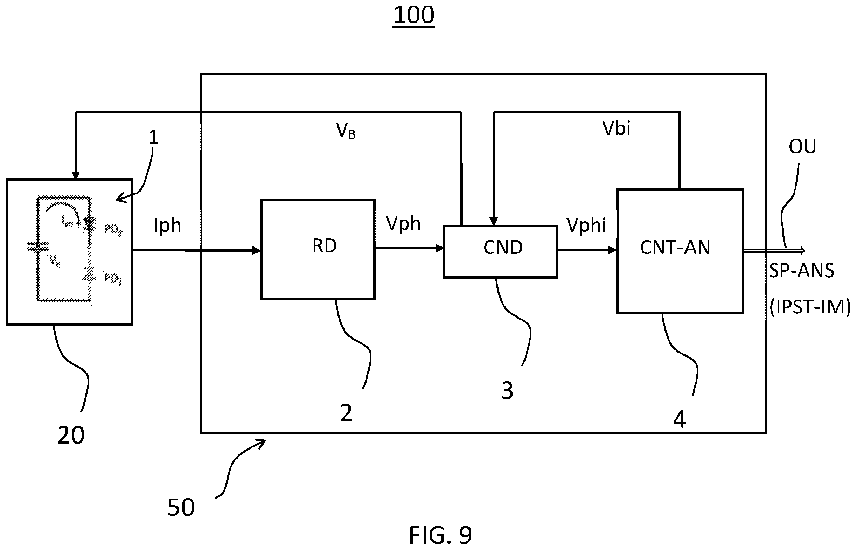

With reference to these possible applications, Figure 9 illustratively shows a spectrum detection system 100 comprising an electromagnetic radiation sensor apparatus 20 and an electronic control and processing module 50. In more detail, the electronic control and processing module 50 is configured to extract and provide on an output OU information related to the spectrum of radiation invading the sensor 10. The electronic control and processing module 50 includes a readout module 2 (RD), a conditioning module 3 (CND), and an analysis and control device 4 (CNT-AN).

According to a first embodiment, described below, the spectrum detection system 100 may be configured to perform spectral analysis of an electromagnetic radiation by providing on the output OU information SP-ANS relating to the measurement of the intensity of the incident radiation as a function of wavelength.

The electromagnetic radiation sensor apparatus 20 includes the sensor device 1. For the purpose of spectral analysis of electromagnetic radiation, the sensor apparatus 20 may include a single sensor 10.

With respect to the control and processing module 50, note that the readout module 2 is configured to convert the current signal Iph to a voltage signal Vph and includes, for example, a trans-impedance amplifier (not shown).

The conditioning module 3 is configured to treat the voltage signal Vph so as to make it suitable for subsequent processing. For example, the conditioning module 3 performs operations such as amplification, filtering, level adaptation, dark current cancellation, and an analog-to-digital conversion of the voltage signals Vph to digital values Vphi.

The analysis and control device 4 is configured to receive digital values Vphi representative of the voltage signals Vph, corresponding to the photocurrent signals generated by the sensor 10 for various bias voltages V_{B}, and perform a spectral analysis of the radiation invading the sensor 1. The analysis and control device 4 may include programmable logic (e.g., ASIC/FPGA) configured to perform such a spectral analysis.

In addition, the analysis and control device 4 is configured to generate digital voltage values Vbi which, through appropriate conditioning (which can be performed by the conditioning module 3) are transformed into analog values of the bias voltage V_{B} to be applied to the sensor 1 to vary its spectral response.

For example, the control and processing module 50 is a ROIC (ReadOut Integrated Circuit) that can be directly integrated into the substrate 25 used to make the sensor 10. Alternatively, the sensor 10 and the ROIC 50 can be made on two different substrates and then connected via bump-bonding or wafer-bonding techniques. Alternatively, sensor 1 and ROIC 50 may be fabricated on different substrates and then connected via a PCB.

As already described, the sensitivity spectrum of sensor 10 can be continuously modified; in particular, several spectral responses intermediate to the extreme ones (obtainable by applying the maximum or minimum bias voltage) shown in Figure 2 can be obtained.

This property offers the possibility of obtaining a large number of spectra, dynamically tunable, through the application of the bias voltage V_{B} and extended in the visible and near-infrared range, allowing the realization of a compact spectral analysis system.

Note that the spectral analysis is based on the knowledge of the spectral responsivity of the sensor 10, this spectral responsivity is determined in a characterization step.

In accordance with another embodiment of the system 100, the system can be configured to operate as a hyperspectral imaging system, i.e., a hyperspectral imaging system IPST-IM. In this case, the sensor apparatus 20 includes a plurality of sensor devices 10, similar to the sensor described above, organized according to a matrix. For example, the sensor apparatus 20 may include millions of sensors 10 each corresponding to a pixel of the hyperspectral image to be acquired.

The electronic control and processing module 50 is, in this case, configured to receive the photocurrents Iph provided by each sensor 1 (corresponding to a pixel) and process them to obtain the hyperspectral image, in which for each pixel the image spectrum of a scene is provided.

The Spectrum 100 detection system is used, for example, in the automotive sector (Fog, Night Vision, augmented vision), in the Machine Vision sector (Industry 4.0, increased machine vision) or in the plastics recycling sector.

### LIST OF THE FIGURE NUMBERS

- sensor device 10
- spectrum detection system 100
- electromagnetic radiation sensor 20
- electronic control and processing module 50
- output OU
- reading module 2
- conditioning module 3
- analysis and control device 4
- First photodiode PD1
- Second photodiode PD2
- bias voltage V_{B}
- photocurrent Iph
- Voltage signal Vph
- digital voltage values Vbi
- substrate 25
- first ohmic contact BC
- second ohmic contact TC
- first face 30
- first doped region 31
- second face 32
- second doped region 33
- layer in a second semiconductor material 34
- third face 35
- doped layer 36
- first metallic layer 37
- second metallic layer 38
- first high doping pocket 39
- second high doping pouch 40
- third metal layer 41
- fourth metal layer 42
- fifth metal layer 43
- insulating layer 44
- free face 45
- first contact pad 46
- second contact pad 47
- third ohmic contact FC
- third high doping pocket 48

## Claims

1. Double photodiode electromagnetic radiation sensor device (10) comprising:
- a substrate (25) in a first semiconductor material defining a first face (12, 30) exposed to electromagnetic radiation (EMR) and a second face (32) opposite the first face;
- a first integrated photodiode (PD1) comprising:
a first doped region (31) included in the substrate (25) so as to extend to the second face (32) and having a first type doping (n);
a second doped region (33) included into the substrate (25) to extend to the second face (32), separated from the first region (31) by a portion of the substrate (25), having a doping of a second type (p+);
- a second integrated photodiode (PD2) comprising said first doped region (31); and:
a layer in a second semiconductor material (34) placed on the second face (32) in contact with the first doped region (31) and such as to define a third face (35) opposed to the second face (32);
a doped layer in the second semiconductor material (36) having a doping of the second type (p+) and overlapping the third face (35);
- metal contacts (BC, TC) arranged to contact the second doped region (33), at the second face (32), and the doped layer (36).

2. Sensor device (10) according to claim 1, in which said metal contacts (BC, TC) comprise:
a first metallic layer (37, BC) placed on the second face (32) in contact with the second doped region (33).

3. Sensor device (10) according to claim 2, further comprising:
a first high doping well (39) having doping of the second type (p+) included in the first doped region (31) and extending to the second face (32);
a second high doping well (40) having doping of the second type (p+) included in the layer in the second semiconductor material (34) and such as to contact the doped layer in the second semiconductor material (36) and a first portion of the first high doping well (39) at the second face (32).

4. Sensor device (10) according to claim 3, wherein:
said metal contacts (BC, TC) comprise a second metal layer (38, TC) placed over a second portion of the first high doping well (39) at the second face (32).

5. Sensor device (10) according to claim 3, wherein:
said metal contacts (BC, TC) comprise a third metal layer (41) covering the doped layer in the second semiconductor material (36) and the second high doping well (40), contacting the first high doping well (39) at the second face (32).

6. Sensor device (10) according to claim 2, wherein:
said metal contacts (BC, TC) comprise a fourth metal layer (42) covering the doped layer in the second semiconductor material (36), being spaced from the second face (32).

7. Sensor device (10) according to claim 2, also comprising:
a layer of electrically insulating material (44) placed over the second face (32) and the doped layer in the second semiconductor material (36);
and wherein:
said first metal layer (37) extends internally to the layer of insulating material from the second face (32) to a free face (45) of the layer of insulating material forming a first contact pad (46);
said metal contacts (BC, TC) comprise a fifth metal layer (43) extending internally to the layer of insulating material from the second face (32) to a free face (45) of the layer of insulating material forming a second contact pad (47).

8. Sensor device (10) according to claim 1, in which the first and/or second semiconductor material is chosen from one of the following types:
(a) III-V semiconductors and their alloys;
(b) II-VI semiconductors and their alloys;
(c) Group IV semiconductors and their alloys.

9. Sensor device (10) according to claim 1, where said first semiconductor material has associated a first band gap Eg1 and the second semiconductor material has associated a second band gap Eg2 smaller than said first band gap.

10. Sensor device according to claim 1, configured to convert the incident electromagnetic radiation (EMR) into photo-detected electric current (Iph) as a function of a respective spectral responsivity dependent on a control voltage (VB).

11. Sensor device (10) according to claims 2 and 10, wherein said metal contacts (BC, TC) define a first (BC) and a second (TC) electrical terminals to which the control electrical voltage (VB) is applicable and from which the photo-detected electric current (Iph) is readable.

12. Sensor device (10) according to claim 1, in which the first and second semiconductor materials are selected so that the sensor device (10) is such that it operates in the visible, near-infrared to part of the short-wave infrared.

13. Sensor device (10) according to claim 4, also including:
a third high doping well (48) having doping of the first type (p+) included in the first doped region (31) and extending to the second face (32);
a further metal layer (FC) placed above said third high doping well (48) at the second face (32) defining a third electrical control terminal of said device.

14. Electromagnetic radiation detection system (100), comprising:
a sensor device (20, 10) according to at least one of the above claims and configured to convert an incident electromagnetic radiation (EMR) into electrical current as a function of a respective spectral responsivity dependent on an adjusting electrical voltage (V_{B});
an electronic control and processing module (50) configured to:
- selectively provide the sensor device (10) with a plurality of adjusting electrical voltage values (V_{B}) adjusting said spectral responsivity so as to obtain a corresponding plurality of detected electric currents (Iph) associated with the incident electromagnetic radiation;
- process values of such detected electric currents (Iph) basing on the adjusting electrical voltage values (V_{B}) and said spectral responsivity, obtaining information (SP-ANS; IPST-IM) related to the incident electromagnetic radiation.

15. System (100) according to claim 14, in which the control and processing module (50) includes:
a reading module (2) configured to receive the plurality of detected electrical currents (Iph) and convert it into a plurality of detected electrical voltages (Vph);
a conditioning module (3) configured to receive the plurality of detected electrical voltages (Vph) and convert it into corresponding digital detected values (Vphi);
an analysis device (4) configured to receive the digital detected values (Vphi) and extrapolate spectrum information (SP-ANS; IPST-IM) of the incident electromagnetic radiation.

## Patentansprüche

1. Doppelfotodioden-Sensorvorrichtung (10) für elektromagnetische Strahlung, umfassend:
- ein Substrat (25) in einem ersten Halbleitermaterial, das eine erste Fläche (12, 30), die elektromagnetischer Strahlung (EMR) ausgesetzt ist, und eine der ersten Fläche gegenüberliegende zweite Fläche (32) definiert;
- eine erste integrierte Fotodiode (PD1), umfassend:
einen ersten dotierten Bereich (31), der in dem Substrat (25) eingeschlossen ist, um sich zu der zweiten Fläche (32) zu erstrecken, und der einen ersten Dotierungstyp (n) aufweist;
einen zweiten dotierten Bereich (33), der in das Substrat (25) eingeschlossen ist, um sich bis zu der zweiten Fläche (32) zu erstrecken, der von dem ersten Bereich (31) durch einen Abschnitt des Substrats (25) getrennt ist und der eine Dotierung eines zweiten Typs (p+) aufweist;
- eine zweite integrierte Fotodiode (PD2), die den ersten dotierten Bereich (31) umfasst; und:
eine Schicht in einem zweiten Halbleitermaterial (34), die auf der zweiten Fläche (32) in Kontakt mit dem ersten dotierten Bereich (31) platziert ist und zwar derart, um eine der zweiten Fläche (32) gegenüberliegende dritte Fläche (35) zu definieren;
eine dotierte Schicht in dem zweiten Halbleitermaterial (36), die eine Dotierung des zweiten Typs (p+) aufweist und die dritte Fläche (35) überlappt;
- Metallkontakte (BC, TC), die angeordnet sind, um den zweiten dotierten Bereich (33) an der zweiten Fläche (32) und die dotierte Schicht (36) zu kontaktieren.

2. Sensorvorrichtung (10) nach Anspruch 1, wobei die Metallkontakte (BC, TC) Folgendes umfassen:
eine erste metallische Schicht (37, BC), die auf der zweiten Fläche (32) in Kontakt mit dem zweiten dotierten Bereich (33) platziert ist.

3. Sensorvorrichtung (10) nach Anspruch 2, ferner umfassend:
eine erste Hochdotierungswanne (39), die eine Dotierung des zweiten Typs (p+) aufweist, in dem ersten dotierten Bereich (31) eingeschlossen ist und sich zu der zweiten Fläche (32) erstreckt;
eine zweite Hochdotierungswanne (40), die eine Dotierung vom zweiten Typ (p+) aufweist, in der Schicht in dem zweiten Halbleitermaterial (34) eingeschlossen ist und derart, dass sie die dotierte Schicht in dem zweiten Halbleitermaterial (36) und einen ersten Abschnitt der ersten Hochdotierungswanne (39) an der zweiten Fläche (32) kontaktiert.

4. Sensorvorrichtung (10) nach Anspruch 3, wobei:
die Metallkontakte (BC, TC) eine zweite Metallschicht (38, TC) umfassen, die über einem zweiten Abschnitt der ersten Hochdotierungswanne (39) an der zweiten Fläche (32) platziert ist.

5. Sensorvorrichtung (10) nach Anspruch 3, wobei:
die Metallkontakte (BC, TC) eine dritte Metallschicht (41) umfassen, die die dotierte Schicht in dem zweiten Halbleitermaterial (36) und die zweite Hochdotierungswanne (40) bedeckt, sodass sie die erste Hochdotierungswanne (39) an der zweiten Fläche (32) kontaktiert.

6. Sensorvorrichtung (10) nach Anspruch 2, wobei:
die Metallkontakte (BC, TC) eine vierte Metallschicht (42) umfassen, die die dotierte Schicht in dem zweiten Halbleitermaterial (36) bedeckt und von der zweiten Fläche (32) beabstandet ist.

7. Sensorvorrichtung (10) nach Anspruch 2, ferner umfassend:
eine Schicht aus elektrisch isolierendem Material (44), die über der zweiten Fläche (32) und der dotierten Schicht in dem zweiten Halbleitermaterial (36) platziert ist;
und wobei:
die erste Metallschicht (37) sich im Inneren der Schicht aus isolierendem Material von der zweiten Fläche (32) zu einer freien Fläche (45) der Schicht aus isolierendem Material erstreckt und ein erstes Kontaktpad (46) ausbildet;
die Metallkontakte (BC, TC) eine fünfte Metallschicht (43) umfassen, die sich im Inneren der Schicht aus isolierendem Material von der zweiten Fläche (32) zu einer freien Fläche (45) der Schicht aus isolierendem Material erstreckt und eine zweite Kontaktfläche (47) ausbildet.

8. Sensorvorrichtung (10) nach Anspruch 1, wobei das erste und/oder zweite Halbleitermaterial aus einem der folgenden Typen gewählt ist:
(a) III-V-Halbleiter und deren Legierungen;
(b) II-VI-Halbleiter und deren Legierungen;
(c) Halbleiter der Gruppe IV und deren Legierungen.

9. Sensorvorrichtung (10) nach Anspruch 1, wobei dem ersten Halbleitermaterial eine erste Bandlücke Eg1 zugehörig ist und dem zweiten Halbleitermaterial eine zweite Bandlücke Eg2 zugehörig ist, die kleiner als die erste Bandlücke ist.

10. Sensorvorrichtung nach Anspruch 1, die konfiguriert ist, um die einfallende elektromagnetische Strahlung (EMR) in fotodetektierten elektrischen Strom (Iph) als Funktion eines jeweiligen spektralen Ansprechvermögens abhängig von einer Steuerspannung (VB) umzuwandeln.

11. Sensorvorrichtung (10) nach Ansprüchen 2 und 10, wobei die Metallkontakte (BC, TC) einen ersten (BC) und einen zweiten (TC) elektrischen Anschluss definieren, an die die elektrische Steuerspannung (VB) anlegbar ist und von denen der fotodetektierte elektrische Strom (Iph) auslesbar ist.

12. Sensorvorrichtung (10) nach Anspruch 1, wobei das erste und das zweite Halbleitermaterial so ausgewählt sind, dass die Sensorvorrichtung (10) derart ist, dass sie im sichtbaren Nahinfrarot bis zu einem Teil des kurzwelligen Infrarots arbeitet.

13. Sensorvorrichtung (10) nach Anspruch 4, ferner einschließend:
eine dritte Hochdotierungswanne (48), die eine Dotierung des ersten Typs (p+) aufweist, die in dem ersten dotierten Bereich (31) eingeschlossen ist und sich zu der zweiten Fläche (32) erstreckt;
eine weitere Metallschicht (FC), die über der dritten Hochdotierungswanne (48) an der zweiten Fläche (32) platziert ist und einen dritten elektrischen Steueranschluss der Vorrichtung definiert.

14. Detektionssystem (100) für elektromagnetische Strahlung, umfassend:
eine Sensorvorrichtung (20, 10) nach mindestens einem der vorhergehenden Ansprüche und konfiguriert, um eine einfallende elektromagnetische Strahlung (EMR) als Funktion eines jeweiligen spektralen Ansprechvermögens abhängig von einer elektrischen Einstellspannung (V_{B}) in elektrischen Strom umzuwandeln;
ein elektronisches Steuerungs- und Verarbeitungsmodul (50), das konfiguriert ist, um:
- die Sensorvorrichtung (10) selektiv mit einer Vielzahl von elektrischen Einstellspannungswerten (V_{B}) zu versehen, die das spektrale Ansprechvermögen einstellen, um eine entsprechende Vielzahl von detektierten elektrischen Strömen (Iph) zu erhalten, die der einfallenden elektromagnetischen Strahlung zugehörig sind;
- Werte solcher detektierter elektrischer Ströme (Iph) basierend auf den elektrischen Einstellspannungswerten (V_{B}) und dem spektralen Ansprechvermögen zu verarbeiten, sodass Informationen (SP-ANS; IPST-IM) bezogen auf die einfallende elektromagnetische Strahlung erhalten werden.

15. System (100) nach Anspruch 14, wobei das Steuer- und Verarbeitungsmodul (50) Folgendes einschließt:
ein Auslesemodul (2), das konfiguriert ist, um die Vielzahl detektierter elektrischer Ströme (Iph) zu empfangen und in eine Vielzahl detektierter elektrischer Spannungen (Vph) umzuwandeln;
ein Konditionierungsmodul (3), das konfiguriert ist, um die Vielzahl von detektierten elektrischen Spannungen (Vph) zu empfangen und in entsprechende digitale detektierte Werte (Vphi) umzuwandeln;
eine Analysevorrichtung (4), die konfiguriert ist, um die digitalen detektierten Werte (Vphi) zu empfangen und Spektruminformationen (SP-ANS; IPST-IM) der einfallenden elektromagnetischen Strahlung zu extrapolieren.

## Revendications

1. Dispositif capteur de rayonnement électromagnétique à double photodiode (10), comprenant :
- un substrat (25) en un premier matériau semi-conducteur définissant une première face (12, 30) exposée à un rayonnement électromagnétique (EMR) et une deuxième face (32) opposée à la première face ;
- une première photodiode intégrée (PD1) comprenant :
une première région dopée (31) incluse dans le substrat (25) de manière à s'étendre jusqu'à la deuxième face (32) et ayant un dopage d'un premier type (n) ;
une seconde région dopée (33) incluse dans le substrat (25) pour s'étendre jusqu'à la deuxième face (32), séparée de la première région (31) par une portion du substrat (25), ayant un dopage d'un second type (p+) ;
- une seconde photodiode intégrée (PD2) comprenant ladite première région dopée (31) ; et :
une couche formée d'un second matériau semi-conducteur (34) placée sur la deuxième face (32) en contact avec la première région dopée (31) et de manière à définir une troisième face (35) opposée à la deuxième face (32) ;
une couche dopée formée du second matériau semi-conducteur (36) ayant un dopage du second type (p+) et recouvrant la troisième face (35) ;
- des contacts métalliques (BC, TC) agencés pour venir en contact avec la seconde région dopée (33), au niveau de la deuxième face (32), et la couche dopée (36).

2. Dispositif capteur (10) selon la revendication 1, dans lequel lesdits contacts métalliques (BC, TC) comprennent :
une première couche métallique (37, BC) placée sur la deuxième face (32) en contact avec la seconde région dopée (33).

3. Dispositif capteur (10) selon la revendication 2, comprenant en outre :
un premier puits fortement dopé (39) ayant un dopage du second type (p+) inclus dans la première région dopée (31) et s'étendant jusqu'à la deuxième face (32) ;
un deuxième puits fortement dopé (40) ayant un dopage du second type (p+) inclus dans la couche formée du second matériau semi-conducteur (34) et de manière à venir en contact avec la couche dopée formée du second matériau semi-conducteur (36) et une première partie du premier puits fortement dopé (39) au niveau de la deuxième face (32).

4. Dispositif capteur (10) selon la revendication 3, dans lequel :
lesdits contacts métalliques (BC, TC) comprennent une deuxième couche métallique (38, TC) placée sur une seconde partie du premier puits fortement dopé (39) au niveau de la deuxième face (32).

5. Dispositif capteur (10) selon la revendication 3, dans lequel :
lesdits contacts métalliques (BC, TC) comprennent une troisième couche métallique (41) recouvrant la couche dopée formée du second matériau semi-conducteur (36) et le deuxième puits fortement dopé (40), venant en contact avec le premier puits fortement dopé (39) au niveau de la deuxième face (32).

6. Dispositif capteur (10) selon la revendication 2, dans lequel :
lesdits contacts métalliques (BC, TC) comprennent une quatrième couche métallique (42) recouvrant la couche dopée formée du second matériau semi-conducteur (36), étant espacée de la deuxième face (32).

7. Dispositif capteur (10) selon la revendication 2, comprenant en outre :
une couche de matériau électriquement isolant (44) placée sur la deuxième face (32) et la couche dopée formée du second matériau semi-conducteur (36) ;
et dans lequel :
ladite première couche métallique (37) s'étend à l'intérieur de la couche de matériau isolant depuis la deuxième face (32) jusqu'à une face libre (45) de la couche de matériau isolant, formant ainsi un premier plot de contact (46) ;
lesdits contacts métalliques (BC, TC) comprennent une cinquième couche métallique (43) s'étendant à l'intérieur de la couche de matériau isolant depuis la deuxième face (32) jusqu'à une face libre (45) de la couche de matériau isolant, formant ainsi un second plot de contact (47).

8. Dispositif capteur (10) selon la revendication 1, dans lequel le premier et/ou le second matériau semi-conducteur sont choisis parmi l'un des types suivants :
(a) semi-conducteurs III-V et leurs alliages ;
(b) semi-conducteurs II-VI et leurs alliages ;
(c) Semi-conducteurs du groupe IV et leurs alliages.

9. Dispositif capteur (10) selon la revendication 1, où audit premier matériau semi-conducteur est associée une première bande interdite Eg1 et au second matériau semi-conducteur est associée une seconde bande interdite Eg2 plus petite que ladite première bande interdite.

10. Dispositif capteur selon la revendication 1, configuré pour convertir le rayonnement électromagnétique (EMR) incident en courant électrique photodétecté (Iph) en fonction d'une sensibilité spectrale respective dépendant d'une tension de commande (VB).

11. Dispositif capteur (10) selon les revendications 2 et 10, dans lequel lesdits contacts métalliques (BC, TC) définissent une première (BC) et une deuxième (TC) borne électrique auxquelles la tension électrique de commande (VB) est applicable et à partir desquelles le courant électrique photodétecté (Iph) est lisible.

12. Dispositif capteur (10) selon la revendication 1, dans lequel les premier et second matériaux semi-conducteurs sont sélectionnés de sorte que le dispositif capteur (10) est tel qu'il fonctionne dans le visible, le proche infrarouge jusqu'à une partie de l'infrarouge à ondes courtes.

13. Dispositif capteur (10) selon la revendication 4, comportant en outre :
un troisième puits fortement dopé (48) ayant un dopage du premier type (p+) inclus dans la première région dopée (31) et s'étendant jusqu'à la deuxième face (32) ;
une couche métallique supplémentaire (FC) placée au-dessus dudit troisième puits fortement dopé (48) au niveau de la deuxième face (32) définissant une troisième borne électrique de commande dudit dispositif.

14. Système de détection de rayonnement électromagnétique (100), comprenant :
un dispositif capteur (20, 10) selon au moins l'une des revendications précédentes et configuré pour convertir un rayonnement électromagnétique (EMR) incident en courant électrique en fonction d'une sensibilité spectrale respective dépendant d'une tension électrique d'ajustement (V_{B}) ;
un module électronique de commande et de traitement (50) configuré pour :
- fournir sélectivement au dispositif capteur (10) une pluralité de valeurs de tension électrique d'ajustement (V_{B}) ajustant ladite sensibilité spectrale de manière à obtenir une pluralité correspondante de courants électriques détectés (Iph) associés au rayonnement électromagnétique incident ;
- traiter des valeurs de tels courants électriques détectés (Iph) sur la base des valeurs de tension électrique d'ajustement (V_{B}) et de ladite sensibilité spectrale, en obtenant des informations (SP-ANS ; IPST-IM) relatives au rayonnement électromagnétique incident.

15. Système (100) selon la revendication 14, dans lequel le module de commande et de traitement (50) comprend :
un module de lecture (2) configuré pour recevoir la pluralité de courants électriques détectés (Iph) et la convertir en une pluralité de tensions électriques détectées (Vph) ;
un module de conditionnement (3) configuré pour recevoir la pluralité de tensions électriques détectées (Vph) et la convertir en valeurs détectées numériques correspondantes (Vphi) ;
un dispositif d'analyse (4) configuré pour recevoir les valeurs numériques détectées (Vphi) et extrapoler des informations de spectre (SP-ANS ; IPST-IM) du rayonnement électromagnétique incident.
